# EUROPEAN PATENT SPECIFICATION

(11) **EP 2 072 636 B1**
(45) Date of publication and mention of the grant of the patent: **31.08.2016**
(21) Application number: 08171268.9
(22) Date of filing: 10.12.2008
(51) Int. Cl.: C23C 14/02, C23C 14/58, C23C 28/04, C23C 28/00, C23C 30/00

(54) **Method of making a coated cutting tool**
Verfahren zum Herstellen eines Schneidwerkzeugs
Procédé de fabrication d'un outil de couper

(30) Priority: 21.12.2007 SE 0702866
(43) Date of publication of application: 24.06.2009
(73) Proprietor: Sandvik Intellectual Property AB, 811 81 Sandviken (SE)
(72) Inventor: Myrtveit, Toril, SE 196 30 Kungsängen (SE)
(74) Representative: Hägglöf, Henrik

(56) References cited:
- DE-A1- 19 809 409
- US-A1- 2001 024 737
- US-A1- 2002 102 400
- FOX-RABINOVICH G ET AL: "Features of self-organization in ion modified nanocrystalline plasma vapor deposited AlTiN coatings under severe tribological conditions" JOURNAL OF APPLIED PHYSICS, vol. 102, no. 7, 2007, XP002591821 AMERICAN INSTITUTE OF PHYSICS US DOI: 10.1063/1.2785947

## Description

### TECHNICAL FIELD

The present invention relates to a method of making a coated cutting tool comprising depositing one or more metallic interlayers in-between deposition of two non-metallic, functional layers. Before each deposition of a metal interlayer, an ion etching step of the non-metallic functional layer is performed. The cutting tools made according to the method of the present invention will exhibit superior life time due to an increased toughness, thus showing better ability to withstand changes in load. In addition, this invention facilitates deposition of thicker PVD coatings without the risk of spalling along the edge line, hence thicker coatings with better flank wear resistance can be deposited.

### BACKGROUND

In general, the life time of a cutting tool is significantly prolonged if a coating is deposited onto its surface. Most cutting tools today are coated with PVD or CVD coatings like Ti(C,N), TiN, (Ti,Al)N, (Ti,Si)N, (Al,Cr)N or Al₂O₃. PVD coatings have several attractive properties compared to CVD coatings, for instance a residual compressive stress in the as-deposited state, no cooling cracks and finer grained coatings.

However, the PVD coatings usually have to be quite thin, since thicker PVD coatings may cause spalling, frittering, so-called edge-line spalling and flaking, either spontaneously, usually around the edge line, or during machining. Since thicker coatings in many applications lead to a longer tool life due to an increased wear resistance, CVD coatings are usually chosen for those applications.

Unfortunately, PVD-coatings, especially arc deposited, suffer from the existence of so-called macros or droplets, which exists as small spheres on the surface of the coating or, buried inside the coating. During the deposition of the coating, these droplets can shadow the incoming flux of charged metal ions, thus creating voids in the coating in the immediate surroundings of the droplet. Due to the subsequent diminished adhesion between the droplet and the coating, the droplet can fall out either during the deposition process or immediately afterwards or even during machining. This may result in an inferior coating quality, with voids, pores or even, in extreme cases, holes straight down to the substrate.

Thicker coatings also have the advantage that the maximum temperature that the substrate is exposed to decreases. A lower substrate temperature decreases the risk of plastic deformation of the cutting edge. Thicker coatings allow for higher cutting forces without initializing plastic substrate deformation.

In the business of cutting tools there is a growing demand for thicker PVD coatings experiencing both the advantages in wear resistance of a thicker coating combined with the toughness of a PVD coating.

Ion etching is a common initial step in the beginning of all kinds of deposition processes. The substrate is usually ion etched prior to deposition to remove surface contaminants and native oxides and nitrides. However, few attempts have been done to use ion etching as an intermediate step.

Depositing metallic layers with PVD techniques is also an established technology in PVD-processes. It is well-known that depositing a metallic layer directly onto the surface of the substrate before depositing the rest of the coating can in some cases enhance adhesion of the coating.

EP 0756019 describes a method of making a PVD-coating for material deforming tools used in punching operations. A PVD-layer composed of (Ti,Al)N, (Ti,Al,Y)N or (Ti,Al,Cr)N or any multilayer thereof is deposited. The surface is then mechanically treated e.g. with sand blasting or metal ion etching to remove any droplets and to achieve a smooth surface. A second, low-friction, PVD coating consisting of MoS₂ is then deposited on top.

US3755866 describes an insert comprising two non-metallic interlayers deposited on top of each other. One layer consists of a fine-grained member of the group consisting of TiC, TaC, ZrC, HfC, VC and NbC. The other layer consists of at least one fine grained member of the group consisting of WC, MoC and CrC. These two layers may or may not be separated by a metallic layer consisting of Co, Ni or Fe. The metallic layer is between 0.1 and 2.0 µm.

EP1136585 describes a self-lubricating coating, consisting of small droplets of metal or other soft material in an otherwise hard coating. Thus, a coating with lower levels of friction is created. The coating is deposited in a sequence consisting of: deposition of a nitride/carbide, followed by ion etching in Ar atmosphere. During the ion etching step a thin metal foil is bombarded with Ar ions, and small metal droplets are emitted. This coating thus consists of layers with small droplets of metal in an otherwise hard coating of a nitride or carbide.

JP2002-103122A describes hard-anodic-oxidation-coatings covering small diameter tools, where the coating consist of an inner Ti layer, followed by a TiCN-layer, an intermediate metallic TiAl-layer and finally covered by an outer TiAlCN-layer.

EP1553210 A1 discloses a method of depositing α-Al₂O₃ layers by PVD technique. In one embodiment, a substrate possibly provided with a primary coating is ion bombarded with either gas ions or metal ions, followed by oxidation of the bombarded surface and finally deposition of a α-Al₂O₃ layer. When metal ions are used for the bombardment, metal ions are implanted into the surface.

US patent application 2001/0024737 discloses a method of making a coated cutting tool. A ceramic layer can be formed by vacuum arc deposition followed by an ion treatment, deposition of a metallic interlayer and deposition of an amorphous carbon film.

US patent application 2002/0102400 discloses wear resistant composite multilayer coating with alternating metallic and ceramic layers. The coating is deposited by filtered cathodic arc.

It is an object of the present invention to provide a method of making a coated cutting tool having a PVD-coating with improved edge toughness.

It is another object of the present invention to provide a method of making a coated cutting tool having thicker PVD-coatings without increasing the risk of spalling, frittering, so-called edge-line spalling and flaking thus obtaining a tool with an increased tool life.

It is another object of the present invention to provide a method of making a coated cutting tool having better flank wear resistance.

It is another object of the present invention to provide a coated cutting tool made according to the method of the invention having the benefits disclosed above.

It has surprisingly been found that, when a non-metallic functional layer is subjected to an ion etching step prior to deposition of a metallic interlayer, the amount of so called droplets inside and on the surface of the non-metallic functional layer is reduced, and in combination with the deposition of the metallic interlayer, the objects above can be fulfilled.

### BRIEF DESCRIPTION OF DRAWINGS

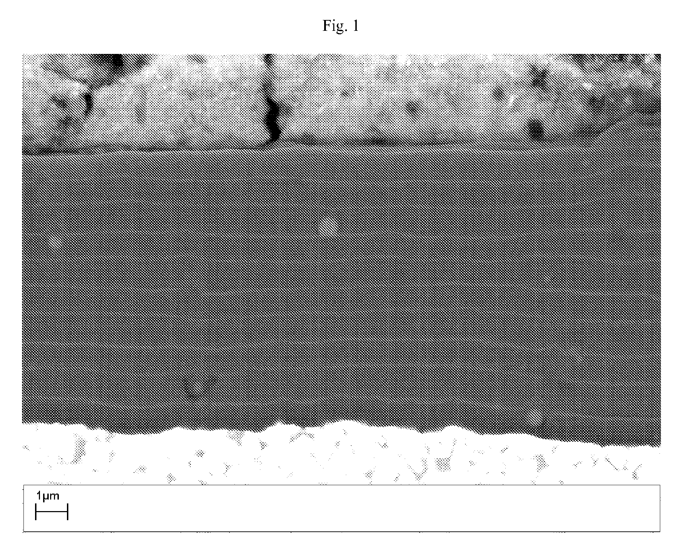

Fig 1 shows a SEM-picture of a polished cross section showing thin metallic interlayers inside the coating. The metallic interlayers are placed every 0.7-1.5 µm distance, the total thickness of the coating is 10 µm.

### DISCLOSURE OF INVENTION

The present invention relates to a method of making a coated cutting tool comprising providing a substrate and coating said substrate with a coating process comprising at least two sequences comprising the steps of:
- depositing a non-metallic, functional layer or layer system,
- subjecting the surface of said non-metallic layer or layer system to an ion etching step,
- depositing at least one metallic interlayer, prior to the beginning of a new sequence.

The three steps, as described above are herein after named a sequence, are repeated any number of times until the desired total coating thickness is achieved.

The number of sequences is preferably between 2 and 20, more preferably between 2 and 10 and most preferably between 3 and 10.

In one embodiment of the present invention, the final deposition step in the coating process is deposition of a non-metallic layer or layer system.

In one embodiment of the present invention, a deposition sequence further comprises, after the ion etching step, deposition of a thin non-metallic layer prior to deposition of the metallic interlayer.

All layers are preferably deposited in the same coating process.

The ion etching step is achieved by ion bombardment with, for example, argon ions or metal ions.

In one embodiment of the present invention, argon ions are used. The argon ions are created by igniting plasma in the deposition chamber which is filled with argon. The argon ions are accelerated towards the substrates which are being kept at a negative potential with a value of preferably 50-300 V, more preferably 100-300 V. The pressure during the etching step is preferably 1-15 µbar, more preferably 1-5 µbar, the temperature is the same as during deposition, preferably 300-800°C, more preferably 450-750°C.

In another embodiment of the present invention, metal ions are used. The deposition chamber is filled with argon, and an arc is ignited at a metal target, thus forming a dense vapor of metal ions. These metal ions are accelerated towards the substrates which are being kept at a high negative potential. The metal ions are preferably one or more of Ti, Zr, Cr, Nb, V, Mo, most preferably Cr. The substrate bias during the metal ion etching step is negative with a value of preferably 300-2000 V, more preferably 500-1300 V. The pressure during the etching step is preferably 1-15 µbar, more preferably 1-5 µbar, the temperature is the same as the same as during deposition, preferably 300-800°C, more preferably 450-750°C.

After the ion etching step, the metallic interlayer is deposited using the same coating process as for the non-metallic layers by changing the atmosphere to an inert gas, e.g. He, Ar, Kr, Xe or a combination of these gases.

By metallic interlayer is herein meant a layer comprising at least 60 at%, preferably at least 70 at%, more preferably at least 80 at% and most preferably at least 90 at% metal elements chosen from one or more of Ti, Mo, Al, Cr, V, Y, Nb, Hf, W, Ta and Zr.

The deposited metallic interlayers can also comprise smaller amounts of other elements but then at a level corresponding to a technical impurity thus not significantly affecting the ductility of the layers.

In one embodiment of the present invention, the metallic interlayer is a pure metal layer where the metal(s) are chosen from Ti, Mo, Al, Cr, V, Y, Nb, Hf, W, Ta, Zr, preferably Ti, Mo, Al, V, Ta, Zr, Cr, most preferably Ti, Al, Zr, Cr, or mixtures thereof, where one of these elements constitute at least 50 at% of the pure metal layer.

In another embodiment of the present invention, the metallic interlayer is a substoichiometric ceramic, preferably a nitride, oxide, carbide or boride, more preferably a nitride MeN, where Me is a metal that can be one or more of the metals included in the case of a pure metal interlayer as described above. The amount of the metal element is at least 60 at%, preferably at least 70 at%, more preferably at least 80 at% and most preferably at least 90 at% of the substoichiometric ceramic.

The average thickness of the metallic interlayers is preferably from 5 nm to 500 nm, more preferably from 10 nm to 200 nm and most preferably from 20 nm to 70 nm.

All thicknesses given herein refer to measurements conducted on a reasonably flat surface being in direct line of sight from the targets. For inserts, being mounted on sticks during deposition, it means that the thickness has been measured on the middle of the flank side. For irregular surfaces, such as those on e.g. drills and end mills, the thicknesses given herein refers to the thickness measured on any reasonably flat surface or a surface having a relatively large curvature and some distance away from any edge or corner. For instance, on a drill, the measurements have been performed on the periphery and on an end mill the measurements has been performed on the flank side.

The non-metallic functional layers or layer systems are composed of nitrides, oxides, borides, carbides, or combinations thereof. Preferably the coating comprises one or more layers of one or more of (Al,Ti)N, TiN, (Al,Cr)N, CrN, Al₂O₃, Ti(B,N), TiB₂, (Zr,Al)N, (Ti,X)N, more preferably (Al,Ti)N, Ti(B,N), (Ti,X)N, where X can be one or more of Si, B, C, Ta, V, Y, Cr, Hf, Zr, and most preferably (Al,Ti)N.

The non-metallic, functional layers or layer systems according to the present invention can have any coating structure common in the art of coating cutting tools.

The layers or layer systems, in-between which the sequence of ion etching and deposition of a metallic interlayer takes place, can be the same or different from each other with regard to structure and composition. By layer system is herein meant at least two layers which are deposited on top of each other without any ion etching step or deposition of a metallic interlayer in-between. One example of such a layer system is a multilayered structure comprising at least 5 individual layers. However, such a multilayered structure can comprise up to several thousands of individual layers.

The thickness of the non-metallic, functional layers or layer systems, can be 0.2-5 µm, preferably 0.3-2 µm, most preferably 0.5-1.5 µm.

The non-metallic layers or layer systems are significantly thicker than the metallic interlayers, the thickness of the non-metallic layers is preferably 3-200 times the thickness of the metallic interlayers, more preferably 5-150 times thicker, most preferably 10-100 times thicker.

The total thickness of the coating can be within a wide range since the etching followed by the metallic interlayers makes it possible to deposit coatings thicker than the conventional PVD coatings. The thickness of the whole coating, which comprises both metallic and non-metallic layers, can be 0.6-15 µm, preferably 1-12 µm, and most preferably 2-10 µm.

In one embodiment of the present invention, a non-metallic PVD-layer or layer system is deposited with a thickness of between 0.2-2 µm which is subsequently etched followed by the deposition of a thin metallic interlayer of Ti with a thickness preferably between 20 to 70 nm. This sequence is repeated until the target coating thickness is achieved.

In another embodiment of the present invention, the metallic layer is an alloy of Ti and Al.

In yet another embodiment of the present invention, the metallic layer is an alloy of Al and Cr.

In one embodiment of the present invention, the coating process can, in addition to the deposition sequences as described above, also further comprise sequences where the metallic interlayer is deposited directly onto the non-metallic layer or layer system, without the ion etching step, in order to decrease the deposition time.

Any PVD technique commonly used when coating cutting tools can be used in the method of the present invention. Preferably cathodic arc evaporation or magnetron sputtering is used, although emerging technologies such as HIPIMS (high power impulse magnetron sputtering) could also be used. Even if the coating according to the present invention is referred to as a "PVD-coating", the coating can also be deposited with for example a PECVD technique (Plasma Enhanced Chemical Vapor Deposition) which will generate coatings with properties closer to those of PVD coatings than conventional CVD coatings.

Substrates suitable for the present invention are preferably cutting tool inserts, or round tools such as drills, end mills etc. The substrate is preferably made of any of cemented carbide, cermets, ceramics, cubic boron-nitride or high speed steels, more preferably cemented carbide. The substrate can be pre-coated with an inner layer deposited directly onto the substrate to ensure a good adhesion to the substrate, the inner layer comprising a pure metal and/or a nitride, preferably Ti and/or TiN, said layer being 0.005-0.5 µm, preferably 0.02-0.2 µm and is deposited within the same coating process as the rest of the layers.

The present invention is useful to make a coated cutting tool comprising a substrate provided with a coating comprising two or more sequences, comprising a metallic interlayer and a non-metallic layer or layer system, which has been made according to the method described above. The metallic interlayer(s) is placed between two non-metallic functional layers or layer systems.

By metallic interlayer is herein meant a layer comprising at least 60 at%, preferably at least 70 at%, more preferably at least 80 at% and most preferably at least 90 at% metal elements chosen from one or more of Ti, Mo, Al, Cr, V, Y, Nb, Hf, W, Ta and Zr.

In one embodiment of the present invention the metallic interlayer is a pure metal layer where the metal(s) are chosen from Ti, Mo, Al, Cr, V, Y, Nb, Hf, W,Ta, Zr or any mixture thereof, preferably Ti, Mo, Al, V, Ta, Zr, most preferably Ti, Al, Zr or mixtures of elements where one of these elements constitute at least 50 at% of the pure metal layer.

In another embodiment of the present invention the metallic interlayer is a substoichiometric ceramic, preferably a nitride, oxide, carbide or boride, more preferably a nitride MeN, where Me is a metal that can be one or more of the metals included in the case of a pure metal interlayer as described above or mixtures thereof. The amount of the metal element is at least 60 at%, preferably at least 70 at%, more preferably at least 80 at% and most preferably at least 90 at% of the substoichiometric ceramic.

The average thickness of the metallic interlayers can be from 5 nm to 500 nm, preferably from 10 nm to 200 nm and most preferably from 20 nm to 70 nm.

The number of metallic interlayers alternated with non-metallic layers is preferably between 2 and 20, more preferably 2 to 10 layers and most preferably between 3-10 layers.

The non-metallic layers or layer systems are composed of nitrides, oxides, borides, carbides, carbonitrides, carbooxynitrides or combinations thereof. Preferably the coating comprises one or more layers of one or more of (Al,Ti)N, TiN, Ti(C,N), (Al,Cr)N, CrN, Al₂O₃, Ti(B,N), TiB₂, (Zr,Al)N, (Ti,X)N, more preferably (Al,Ti)N, Ti(B,N), (Ti,X)N where X can be one or more of Si, B, C, Ta, V, Y, Cr, Hf, Zr, and most preferably (Al,Ti)N.

The layers or layer systems, in-between which the metallic interlayer is placed, can be the same or different from each other with regard to structure and composition. By layer system is herein meant at least two layers which are deposited on top of each other without any metallic interlayer in-between. One example of such a layer system is a multilayered structure comprising at least 5 individual layers. However, such a multilayered structure can comprise up to several thousands of individual layers.

The thickness of the non-metallic, functional layers, placed between the metallic interlayers, can be 0.2-5 µm, preferably 0.3-2 µm, most preferably 0.5-1.5 µm.

The non-metallic layers are significantly thicker than the metallic interlayers, the thickness of the non-metallic layers are preferably 3-200 times the thickness of the metallic interlayers, more preferably 5-150 times thicker, most preferably 10-100 times thicker.

The thickness of the whole coating comprising both metallic and non-metallic layers can be from 0.6 to 15 µm, preferably from 1 to 12 µm and most preferably from 2 to 10 µm.

In one embodiment of the present invention, the non-metallic, functional layers or layer systems has a thickness of between 0.2 and 2 µm, and the thin metallic interlayer is Ti with a thickness preferably between 20 and 70 nm.

In another embodiment of the present invention, the metallic interlayer is an alloy of Ti and Al.

In yet another embodiment of the present invention, the metallic interlayer is an alloy of Al and Cr.

Substrates suitable for the present invention are preferably cutting tool inserts, or round tools such as drills, end mills etc. The substrate is preferably made of any one of cemented carbide, cermets, ceramics, cubic boronitride or high speed steels, more preferably cemented carbide.

### EXAMPLE 1

Cemented carbide inserts ofthree different geometries, CNMG120408-MM, R290-12T0308M-KM and R390-11T0308M-PM were used. Inserts A were coated in accordance with prior art, by depositing a 6 µm thick homogenous Ti_{0.33}Al_{0.67}N layer as measured in the middle of the flank side. The coating was deposited by cathodic arc evaporation in an N₂-atmosphere and the inserts were mounted on a 3-fold rotating substrate table and the layer was deposited from two pairs of Ti_{0.33}Al_{0.67}-targets.

Inserts B were coated according to the present invention. The same deposition conditions as for inserts A were applied except that, after having deposited a layer with a thickness 0.7-0.8 µm, deposition was stopped, and the reactor chamber was filled with Ar. A negative bias was applied to the inserts and the plasma was ignited, and the inserts were ion etched, i.e., bombarded with Ar-ions. After ion bombardment, the deposition was restarted. Keeping the reactor filled with Ar, one pair of Ti-targets were ignited and a thin, approximately 30 nm, metallic Ti layer deposited. Then the reactor was filled with N₂-gas and a new Ti_{0.33}Al_{0.67}N-layer was deposited. This procedure was repeated 8 times until a total coating thickness of 10 µm was achieved. The thickness of the Ti_{0.33}Al_{0.67}N-layers varied between 1.0-1.5 µm. As a final step, a surface treatment was conducted where the inserts again were subject to ion bombardment before the deposition cycle was terminated and the chamber opened.

### EXAMPLE 2

Cemented carbide inserts of geometry CNMG120408-MM were coated with a coating wherein insert C was coated in accordance with prior art, by depositing a 4 µm aperiodic multilayered (Ti,Al)N coating by using cathodic arc evaporation in an N₂-atmosphere. The insert were mounted on a 3-fold rotating substrate table arranged in order to obtain the aperiodic structure. The multilayered coating was deposited from two pair of Ti_{0.33}Al_{0.67}-targets and one pair of Ti_{0.84}Al_{0.16}-targets being run simultaneously.

Insert D was coated in accordance with the present invention. The deposition conditions were the same as for insert C but after having reached a thickness of 1.5 µm, deposition was stopped, and the reactor chamber was filled with argon. The inserts were argon ion etched, and a thin metallic layer, approx. 30 nm, of Ti_{0.84}Al_{0.16} was deposited. Filling the reactor with N₂-gas, a new multilayer of Ti_{0.33}Al_{0.67}N/Ti_{0.84}Al_{0.16}N was deposited. The procedure was repeated until a final coating thickness of 8 µm was achieved. All coating thicknesses are measured in the middle of the flank side of a CNMG insert which has been deposited mounted on a stick.

### Explanations to examples 3-5:

**The following expressions/terms are commonly used in metal cutting, and explained in the table below:**

| | |
|---|---|
| V_{c} (m/min): | cutting speed in meters per minute |
| f_{z} (mm/tooth): | feed rate in millimeter per tooth |
| z: (number) | number of teeth in the cutter |
| aₑ (mm): | radial depth of cut in millimeter |
| aₚ (mm): | axial depth of cut in millimeter |
| D (mm): | cutter diameter in millimeter |

### EXAMPLE 3

**Inserts A (prior art) and B (invention) from Example 1 as well as inserts C (prior art) and insert D (invention) from Example 2, all with geometry CNMG120408-MM, was tested in a turning operation during the following cutting conditions:**

| | |
|---|---|
| Work piece material: | Hard steel Ovako 825 B |
| V_{c}= | 160 m/min |
| f_{z}= | 0.3 mm/tum |
| a= | 2 mm |
| Coolant: | emulsion |

Tool life criterion was a flank wear exceeding 0.3 mm or insert failure. Decisive difference in wear type for increasing the tool life was less crater wear.
Insert A (prior art) lasted 8 minutes in this application, whereas insert B (invention), lasted 12 minutes.
Insert C (prior art) lasted 13 minutes, whereas insert D (invention) lasted 21 minutes.

### EXAMPLE 4

**Inserts A (prior art) and B (invention) from Example 1 with geometry R390-11T0308M-PM were tested in a milling operation during the following cutting conditions:**

| | |
|---|---|
| Work piece material: | hardened Dievar HRc=47 |
| V_{c}= | 120 m/min |
| f_{z}= | 0.12 mm/tooth |
| aₑ= | 2 mm |
| aₚ | 4 mm |
| z= | 1 |
| D= | 32 mm |
| Coolant: | emulsion |

Tool life criterion was flank wear more than 0.2 mm or fritting more than 0.3 mm.

Insert A (prior art) lasted only 13 minutes in this application, whereas insert B (invention) lasted 48 minutes. Decisive difference in wear type for increasing the tool life was less chipping in the edge line combined with less flank wear.

### EXAMPLE 5

**Inserts A (prior art) and B (invention) from Example 1 with geometry R290-12T0308M-KM were tested in a milling operation during the following cutting conditions:**

| | |
|---|---|
| Work piece material: | Nodular cast iron, SS0727 |
| V_{c}= | 400 m/min |
| f_{z}= | 0.15 mm/tooth |
| aₑ= | 110 mm |
| aₚ | 3 mm |
| z= | 1 |
| D= | 125 mm |

Tool life criterion was flank wear more than 0.3 mm or fritting more than 0.4 mm.
Under dry conditions, insert A (prior art) lasted 12 minutes in this application, whereas insert B (invention) lasted 20 minutes.
Under wet conditions, insert A (prior art) lasted 19 minutes, whereas insert B (invention), lasted 35 minutes. Decisive difference in wear type for increasing the tool life was less chipping of the edge line combined with less flank wear.

## Claims

1. A method of making a coated cutting tool comprising providing a substrate and coating said substrate with a coating process comprising a sequence comprising the steps of:
- depositing a non-metallic PVD layer or layer system being composed of nitrides, oxides, borides, carbides or combinations thereof,
- subjecting the surface of said non-metallic PVD layer or layer system to an ion etching step,
- depositing at least one metallic interlayer on the etched non-metallic PVD layer or layer system, wherein the metallic interlayer comprises metal element(s) chosen from one or more of Ti, Mo, Al, Cr, V, Y, Nb, Hf, W, Ta, Zr, and is either
- a pure metal layer, where the metal(s) are chosen from the metal elements or any mixture thereof, or
- a substoichiometric ceramic being a nitride, oxide, carbide or boride, having an amount of the metal element(s) of at least 60 at%,
characterized that the coating process comprises at least two times said sequence.

2. A method according to claim 1 **characterized in that** the ion etching step is performed with argon ions.

3. A method according to claim 1 **characterized in that** the ion etching step is performed with metal ions.

4. A method according to any of the preceding claims **characterized in that** the coating process is PVD.

5. A method according to any of the preceding claims **characterized in that** the metallic interlayer is a pure metal layer where the metal(s) are chosen from Ti, Mo, Al, Cr, V, Y, Nb, Hf, W,Ta, Zr or any mixture thereof.

6. A method according to any of claims 1-4 **characterized in that** the metallic interlayer is a nitride, MeN, where Me is a metal element that is one or more of Ti, Mo, Al, Cr, V, Y, Nb, Hf, W,Ta, Zr, or mixtures thereof, and the amount of Me is at least 80 at%.

7. A method according to claim 6 **characterized in that** the amount of Me is at least 90 at%.

8. A method according to any of the preceding claims **characterized in that** the composition of the deposited, non-metallic layers or layer systems composed of nitrides, oxides, borides, carbides, or combinations thereof, are one or more of (Al,Ti)N, TiN, Ti(C,N), (Al,Cr)N, CrN, Al₂O₃, Ti(B,N), TiB₂, (Zr,Al)N, (Ti,X)N, where X can be one or more of Si, B, C, Ta, V, Y, Cr, Hf, Zr.

9. A method according to any of the preceding claims **characterized in that** the thickness of the metallic layers is 5 to 500 nm.

10. A method according to any of the preceding claims **characterized in that** the thickness of the non-metallic layer or layer systems is 3 to 200 times the thickness of the metallic interlayers.

11. A method according to any of the preceding claims **characterized in that** the total coating thickness is 0.5 to 15 µm.

12. A method according to any of the preceding claims **characterized in that** the coating process comprises between 2 and 20 sequences comprising the steps of:
- depositing a non-metallic PVD layer or layer system being composed of nitrides, oxides, borides, carbides or combinations thereof,
- subjecting the surface of said non-metallic PVD layer or layer system to an ion etching step,
- depositing at least one metallic interlayer on the etched non-metallic PVD layer or layer system.

## Patentansprüche

1. Verfahren zum Herstellen eines beschichteten Schneidwerkzeugs, welches die Bereitstellung eines Substrats und das Beschichten des Substrats mit einem Beschichtungsverfahren aufweist, welches eine Folge von Schritten aufweist mit:
- Abscheiden einer nichtmetallischen PVD-Schicht oder eines Schichtsystems, welches aus Nitriden, Oxiden, Boriden, Carbiden oder Kombinationen hieraus besteht,
- einem lonenätzschritt, Aussetzen der Oberfläche aus einer nichtmetallischen PVD-Schicht oder eines Schichtsystems,
- Abscheiden zumindest einer metallischen Zwischenschicht auf der geätzten nichtmetallischen PVD-Schicht oder dem Schichtsystem, wobei die metallische Zwischenschicht ein Metallelement beziehungsweise Metallelemente aufweist, die ausgewählt sind aus einem oder mehreren der Elemente Ti, Mo, Al, Cr, V, Y, Nb, Hf, W, Ta, Zr und die entweder
- eine reine Metallschicht ist, wobei das Metall/die Metalle ausgewählt sind aus den Metallelementen oder Mischungen hieraus, oder
- einer unter unterstoichiometrischen Keramik, die ein Nitrid, Oxid, Carbid oder Borid ist, mit einer Menge des Metallelements/der Metallelemente von zumindest 60 Atomprozent,
**dadurch gekennzeichnet, dass** der Beschichtungsvorgang zumindest zweimal die erwähnte Folge von Schritten aufweist.

2. Verfahren nach Anspruch 1, **dadurch gekennzeichnet, dass** der lonenätzschritt mit Argonionen ausgeführt wird.

3. Verfahren nach Anspruch 1, **dadurch gekennzeichnet, dass** der lonenätzschritt mit Metallionen ausgeführt wird.

4. Verfahren nach einem der vorstehenden Ansprüche, **dadurch gekennzeichnet, dass** der Beschichtungsvorgang PVD (physikalische Dampfabscheidung) ist.

5. Verfahren nach einem der vorstehenden Ansprüche, **dadurch gekennzeichnet, dass** die metallische Zwischenschicht eine reine Metallschicht ist, bei welcher das Metall/die Metalle ausgewählt sind aus Ti, Mo, Al, Cr, V, Y, Nb, Hf, W, Ta, Zr oder Mischungen von diesen.

6. Verfahren nach einem der Ansprüche 1 bis 4, **dadurch gekennzeichnet, dass** die metallische Zwischenschicht ein Nitrid, MeN ist, wobei Me ein Metallelement ist, welches aus einem oder mehreren von Ti, Mo, Al, Cr, V, Y, Nb, Hf, W, Ta, Zr oder Mischungen von diesen besteht, wobei die Menge an Me zumindest 80 Atomprozent beträgt.

7. Verfahren nach Anspruch 6, **dadurch gekennzeichnet, dass** die Menge an Me zumindest 90 Atomprozent beträgt.

8. Verfahren nach einem der vorstehenden Ansprüche, **dadurch gekennzeichnet, dass** die Zusammensetzung der abgeschiedenen, nicht metallischen Schichten oder Schichtsysteme, die aus Nitriden, Oxiden, Boriden, Carbiden oder Kombinationen hieraus zusammengesetzt sind, eine oder mehrere der folgenden sind: (Al, Ti)N, TiN, Ti(C, N), (Al, Cr)N, CrN, Al₂O₃, Ti(B, N), TiB₂, (Zr, Al)N, (Ti, X)N, wobei X eines oder mehrere der Elemente Si, B, C, Ta, V, Y, Cr, Hf und Zr sein kann.

9. Verfahren nach einem der vorstehenden Ansprüche, **dadurch gekennzeichnet, dass** die Dicke der metallischen Schichten 5-500 nm beträgt.

10. Verfahren nach einem der vorstehenden Ansprüche, **dadurch gekennzeichnet, dass** die Dicke der nicht metallischen Schicht oder Schichtsysteme 3-200 mal die Dicke der metallischen Zwischenschichten beträgt.

11. Verfahren nach einem der vorstehenden Ansprüche, **dadurch gekennzeichnet, dass** die Gesamtbeschichtungsdicke 0,5-15 µm beträgt.

12. Verfahren nach einem der vorstehenden Ansprüche, **dadurch gekennzeichnet, dass** der Beschichtungsvorgang zwischen 2 und 20 Sequenzen aufweist mit den Schritten:
- Abscheiden einer nicht metallischen PVD-Schicht oder eines Schichtsystems, das aus Nitriden, Oxiden, Boriden, Carbiden oder Kombinationen von diesen zusammengesetzt ist,
- einem lonenätzschritt, Aussetzen der Oberfläche der nicht metallischen PVD-Schicht oder des Schichtsystems,
- Abscheiden zumindest einer metallischen Zwischenschicht auf der geätzten nicht metallischen PVD-Schicht oder dem Schichtsystem.

## Revendications

1. Procédé de fabrication d'un outil de coupe revêtu comprenant le fait de fournir un substrat et le fait de revêtir ledit substrat avec un procédé de revêtement comprenant une séquence comprenant les étapes consistant à :
- déposer une couche ou un système de couches de dépôt PVD non métallique qui est composé de nitrures, d'oxydes, de borures, de carbures ou de combinaisons de ceux-ci,
- soumettre la surface de ladite couche ou dudit système de couches de dépôt PVD métallique à une étape d'attaque ionique,
- déposer au moins une couche intermédiaire métallique sur la couche ou le système de couches de dépôt PVD non métallique attaqué, dans lequel la couche intermédiaire métallique comprend un ou plusieurs éléments métalliques choisis parmi un ou plusieurs de Ti, Mo, Al, Cr, V, Y, Nb, Hf, W, Ta, Zr, et est soit
- une couche métallique pure, où la ou les métaux sont choisis à partir des éléments métalliques ou tout mélange de ceux-ci, soit
- une céramique sub-stoechiométrique qui est un nitrure, un oxyde, un carbure ou un borure, ayant une quantité du ou des éléments métalliques d'au moins 60 % atomiques,
**caractérisé en ce que** le procédé de revêtement comprend au moins deux fois ladite séquence.

2. Procédé selon la revendication 1 **caractérisé en ce que** l'étape d'attaque ionique est réalisée avec des ions argon.

3. Procédé selon la revendication 1 **caractérisé en ce que** l'étape d'attaque ionique est réalisée avec des ions métalliques.

4. Procédé selon l'une quelconque des revendications précédentes **caractérisé en ce que** le procédé de revêtement est un dépôt PVD.

5. Procédé selon l'une quelconque des revendications précédentes **caractérisé en ce que** la couche intermédiaire métallique est une couche métallique pure où le ou les métaux sont choisis parmi Ti, Mo, Al, Cr, V, Y, Nb, Hf, W, Ta, Zr, ou tout mélange de ceux-ci.

6. Procédé selon l'une quelconque des revendications 1 à 4 **caractérisé en ce que** la couche intermédiaire métallique est un nitrure, MeN, où Me est un élément métallique qui est un ou plusieurs parmi Ti, Mo, Al, Cr, V, Y, Nb, Hf, W, Ta, Zr, ou des mélanges de ceux-ci, et la quantité de Me est d'au moins 80 % atomiques.

7. Procédé selon la revendication 6 **caractérisé en ce que** la quantité de Me est d'au moins 90 % atomiques.

8. Procédé selon l'une quelconque des revendications précédentes **caractérisé en ce que** la composition des couches non métalliques ou des systèmes de couches, déposés sont composés de nitrures, d'oxydes, de borures, de carbures, ou de combinaisons de ceux-ci, sont un ou plusieurs parmi (Al, Ti)N, TiN, Ti(C, N), (Al, Cr)N, CrN, Al₂O₃, Ti(B, N), TiB₂, (Zr, Al)N, (Ti, X)N, où X peut être un ou plusieurs parmi Si, B, C, Ta, V, Y, Cr, Hf, Zr.

9. Procédé selon l'une quelconque des revendications précédentes **caractérisé en ce que** l'épaisseur des couches métalliques est de 5 à 500 nm.

10. Procédé selon l'une quelconque des revendications précédentes **caractérisé en ce que** l'épaisseur de la couche ou du système de couches non métallique est de 3 à 200 fois l'épaisseur des couches intermédiaires métalliques.

11. Procédé selon l'une quelconque des revendications précédentes **caractérisé en ce que** l'épaisseur de revêtement totale est de 0,5 à 15 µm.

12. Procédé selon l'une quelconque des revendications précédentes **caractérisé en ce que** le procédé de revêtement comprend entre 2 et 20 séquences comprenant les étapes consistant à :
- déposer une couche ou un système de couches de dépôt PVD non métallique qui est composé de nitrures, d'oxydes, de borures, de carbures ou de combinaisons de ceux-ci,
- soumettre la surface de ladite couche ou dudit système de couches de dépôt PVD métallique à une étape d'attaque ionique,
- déposer au moins une couche intermédiaire métallique sur la couche ou le système de couches de dépôt PVD non métallique attaqué.
